**Europäisches Patentamt**

**European Patent Office**

**Office européen des brevets**

(19)

(11) Veröffentlichungsnummer: **0 143 380**
**B1**

(12) **EUROPÄISCHE PATENTSCHRIFT**

(45) Veröffentlichungstag der Patentschrift:
15.02.89

(21) Anmeldenummer: 84113573.4

(22) Anmeldetag: 10.11.84

(51) Int. Cl.⁴: **G 03 C 1/70,** G 03 C 1/68,
G 03 F 7/10

(54) Fotoresist-Zusammensetzungen.

(30) Priorität: 26.11.83 DE 3342851

(43) Veröffentlichungstag der Anmeldung:
05.06.85 Patentblatt 85/23

(45) Bekanntmachung des Hinweises auf die Patenterteilung:
15.02.89 Patentblatt 89/7

(84) Benannte Vertragsstaaten:
AT CH DE FR GB IT LI NL SE

(56) Entgegenhaltungen:
EP-A-0 019 122
EP-A-0 047 184

Die Akte enthält technische Angaben, die nach
dem Eingang der Anmeldung eingereicht wurden
und die nicht in dieser Patentschrift enthalten sind.

(73) Patentinhaber: **MERCK PATENT GESELLSCHAFT
MIT BESCHRÄNKTER HAFTUNG, Frankfurter
Strasse 250 Postfach 4119, D-6100 Darmstadt (DE)**

(72) Erfinder: **Härtner, Hartmut, Dr., Mathildenweg 9,
D-6109 Mühltal (DE)**
Erfinder: **Merrem, Hans-Joachim, Dr., Grüner
Weg 1, D-6104 Seeheim (DE)**
Erfinder: **Klug, Rudolf, Dr., Grünewaldstrasse 25,
D-8750 Aschaffenburg (DE)**

EP 0 143 380 B1

## Beschreibung

Die Erfindung betrifft Fotoresist-Zusammensetzungen zur Ausbildung von Reliefstrukturen aus hochwärmebeständigen Polymeren.

Fotolacke zur Ausbildung von Reliefstrukturen aus hochwärmebeständigen Polymeren werden in großem Umfang bei der Herstellung elektrischer und elektronischer Bauelemente, von Ätzreserven und Galvanikreserven oder von Druckformen verwendet. Aus beispielsweise den Patent-Schriften DE-PS-2 308 830/USP-3 957 512, DE-PS-2 437 348/USP Re. 39 186, DE-PS-2 437 368/USP-4 045 223 und DE-PS-2 437 422/USP-4 088 489 sowie den deutschen Patentanmeldungen P-3 227 584 und P-3 233 912 sind Verfahren zur Herstellung solcher Reliefstrukturen aus hochwärmebeständigen Polymeren und für diese Zwecke geeignete Fotolacke bzw. die dazu verwendeten fotoempfindlichen löslichen polymeren Vorstufen bekannt. Fotolacke der beschriebenen Art enthalten in der Regel strahlungsempfindliche, lösliche polymere Vorstufen, die esterartig an Carboxylgruppen gebundene strahlungsreaktive Gruppen tragen. Sie werden auf ein Substrat in Form einer Schicht aufgetragen, die Schicht wird getrocknet und dann durch eine Negativvorlage bildmäßig belichtet. An den bestrahlten Stellen findet dadurch eine Vernetzung statt, die die Löslichkeit des aufgetragenen Materials dort drastisch verringert. Die nicht bestrahlten Schichtteile werden dann mit Hilfe eines Entwicklers vom Substrat abgelöst; die verbleibenden Reliefstrukturen können durch Tempern in hochwärmebeständige Polymere überführt werden, die Temperaturen von 250 - 400° C ohne nachteilige Auswirkung auf Kantenschärfe und Auflösung der Bildmuster überstehen.

Gemäß den vorgenannten Patentschriften sind die löslichen polymeren Vorstufen (Präpolymeren) Polyadditions- oder Polykondensationsprodukte aus carbocyclischen oder heterocyclischen Verbindungen mit zwei zu Polyadditions- oder Polykondensationsreaktionen befähigten funktionellen Gruppen sowie mit teilweise in ortho- oder peri-Stellung dazu esterartig an Carboxylgruppen gebundenen strahlungsreaktiven Resten und mit diesen funktionellen Gruppen umsetzbare Diamine, Diisocyanate, Bis-säurechloride oder Dicarbonsäuren, die mindestens ein cyclisches Strukturelement enthalten. Es werden eine Anzahl strahlungsreaktiver Reste aufgezählt, die für die Vernetzung des Fotolackes bei der Bestrahlung verantwortlich sind. Allerdings zeigt sich, daß zur ausreichenden Vernetzung dieser Fotolacke bei Bestrahlung mit einer üblichen UV-Strahlenquelle Bestrahlungszeiten von mindestens 2 Minuten, meist sogar 3 bis 15 Minuten, erforderlich sind; diese Zeiten lassen sich, wie aus den genannten Schriften ersichtlich, auch durch den Zusatz üblicher Photosensibilisatoren oder copolymerisierbarer Maleinimide nicht nennenswert verkürzen.

Gemäß den Zusatzpatenten DE-PS-2 919 840/USP-4 292 398, DE-PS-2 919 823/USP-4 329 556 und DE-PS-2 919 841/USP-4 287 294 werden die Fotolacke dahingehend modifiziert, daß als Fotoinitiatoren aromatische Sulfonylazide zugemischt werden. Hierdurch wird eine Reduktion der notwendigen Bestrahlungszeiten solcher Fotolacke auf bestenfalls 60 Sekunden ermöglicht.

In der deutschen Patentanmeldung P-3 227 584 entspricht der nicht vorveröffentlichten EP-A-99 525, werden die strahlungsreaktiven Gruppen von Polyamidester-Präpolymeren teilweise oder vollständig durch esterartig gebundene, mit Allylalkohol und/oder Allythiol veretherten mehrwertigen Alkoholen modifiziert. In der deutschen Patentanmeldung P-3 233 912, entspricht der nicht vorveröffentlichten EP-A-103 225, werden den Polyamidester-Präpolymeren copolymerisierbare Allylverbindungen zugemischt. Durch diese Maßnahmen wird eine Reduktion der notwendigen Bestrahlungszeiten auf etwa 35 Sekunden erreicht. Auch dies ist jedoch für die Verwendung derartiger Fotolacke in der Massenproduktion elektronischer Bauteile noch eine unerwünscht lange Bestrahlungsdauer.

Eine Steigerung der Lichtempfindlichkeit von Fotolacken enthaltend lösliche, strahlungsreaktive Polyamidester-Harze durch gleichzeitigen Zusatz von strahlungsempfindlichen, polymerisierbaren, polyfunktionellen Acrylatverbindungen und von aromatischen, halogensubstituierten Bisimidazol-Photoinitiatoren wird ferner in der EP-OS-47 184/USP-4 369 247 beschrieben. Solche Fotolacke zeigen zwar eine gute Lichtempfindlichkeit, der Zusatz der Bisimidazol-Photoinitiatoren hat jedoch Nachteile. So kann beispielsweise der Zusatz von Bisimidazol-Verbindungen zu einer unerwünschten, vorzeitigen Polyimidbildung in Lösung führen, wodurch die Haltbarkeit der Fotolacklösung beträchtlich verringert wird. Auch können beispielsweise bei der späteren Aushärtung der Reliefstrukturen bei hohen Temperaturen die Halogensubstituenten abgespalten werden und ihrerseits zu einer unerwünschten Beeinflusung der Materialien, besonders der Substrate, führen. Ferner neigen Fotolacke gemäß EP-OS-47 184 zu vorzeitiger Polymerisation, wodurch die Stabilität solcher Fotolacke ebenfalls deutlich beeinträchtigt wird.

Aufgabe der vorliegenden Erfindung ist somit die Modifizierung derartiger Fotoresist-Zusammensetzungen, daß eine ausreichende Vernetzung der damit hergestellten Beschichtungen schon nach deutlich kürzeren Bestrahlungszeiten erzielt wird, die Stabilität der Fotolacklösungen sowie die Weiterverarbeitung der Fotolacke und die Eigenschaften der erhaltenen Produkte jedoch durch die Modifizierung nicht beeinträchtigt werden.

Es wurde gefunden, daß überraschenderweise deutlich kürzere Bestrahlungszeiten bei derartigen Fotoresist-Zusammensetzungen ausreichend sind und auch deren chemische, thermische und mechanische Beständigkeit sowie der daraus hergestellten Reliefstrukturen aus hochwärmebeständigen Polymeren den in der Praxis gestellten hohen Anforderungen entsprechen, wenn in solchen Fotoresist-Zusammensetzungen zusätzlich

a) mindestens eine strahlungsreaktive, copolymerisierbare Vinyl- oder Allylverbindung, in der die Vinyl- bzw. Allylgruppe(n) über eine funktionelle Gruppe gebunden ist (sind), als Comonomer

und

b) mindestens eine Verbindung vom Typ der N-Azidosulfonylaryl-maleinimide als Fotoinitiator enthalten sind.

Gegenstand der Erfindung sind somit Fotoresist-Zusammensetzungen zur Ausbildung von Reliefstrukturen aus hochwärmebeständigen Polymeren, enthaltend lösliche Polyamidester-Präpolymere, die esterartig an Carboxylgruppen gebundene, strahlungsreaktive Reste tragen, in denen zusätzlich

a) mindestens eine strahlungsreaktive, copolymerisierbare Vinyl- oder Allylverbindung, in der die Vinyl- bzw. Allylgruppe(n) über eine funktionelle Gruppe gebunden ist (sind), als Comonomer

und

b) mindestens eine Verbindung vom Typ der N-Azidosulfonylaryl-maleinimide als Fotoinitiator enthalten sind.

Gegenstand der Erfindung ist ferner die Verwendung einer Kombination aus

a) mindestens einer strahlungsreaktiven, copolymerisierbaren Vinyl- oder Allylverbindung. in der die Vinyl- bzw. Allylgruppe(n) über eine funktionelle Gruppe gebunden ist (sind).

und

b) mindestens einer Verbindung vom Typ der N-Azidosulfonylaryl-maleinimide in Fotoresist-Zusammensetzungen zur Ausbildung von Reliefstrukturen aus hochwärmebeständigen Polymeren, enthaltend lösliche Polyamidester-Präpolymere, die esterartig an Carboxylgruppen gebundene, strahlungsreaktive Reste tragen.

Gegenstand der Erfindung ist weiterhin ein Verfahren zur Herstellung von Reliefstrukturen aus hochwärmebeständigen Polymeren durch Beschichtung eines Substrates mit einer Fotoresist-Zusammensetzung, enthaltend lösliche Polyamidester-Präpolymere, die esterartig an Carboxylgruppen gebundene, strahlungsreaktive Reste tragen, Trocknen der Schicht, bildmäßiges Belichten der Schicht, Ablösen der nicht bestrahlten Schichtteile und gegebenenfalls anschließendes Tempern der erhaltenen Reliefstrukturen, dadurch gekennzeichnet, daß die Beschichtung mit einer Fotoresist-Zusammensetzung erfolgt, die

a) mindestens eine strahlungsreaktive, copolymerisierbare Vinyl- oder Allylverbindung, in der die Vinyl- bzw. Allylgruppe(n) über eine funktionelle Gruppe gebunden ist (sind), als Comonomer

und

b) mindestens eine Verbindung vom Typ der N-Azidosulfonylaryl-maleinimide als Fotoinitiator enthält.

Bei den den Fotolacken erfindungsgemäß zur Verkürzung der Bestrahlungszeiten zugesetzten Comonomeren handelt es sich um strahlungsreaktive, copolymerisierbare Vinyl- oder Allylverbindungen, in denen die Vinyl- bzw. Allylgruppe(n) über eine funktionelle Gruppe gebunden ist (sind).

Insbesondere sind darunter solche Verbindungen zu verstehen, in denen die Vinyl- bzw. Allylgruppe(n) über ein Sauerstoff-, Schwefel- oder Stickstoffatom oder über eine Carbonyl-, Carboxyl-, SO- oder $SO_2$-Gruppe gebunden ist (sind).

Vinylverbindungen können beispielsweise sein Vinylether bzw. -thioether von ein- oder mehrwertigen aliphatischen oder aromatischen Alkoholen bzw. Thiolen, aliphatische und aromatische Vinylsulfone, Acetale bzw. Thioketale von ein- oder mehrwertigen aliphatischen Alkoholen bzw. Thiolen mit Acrolein sowie Acrylester bzw. Methacrylester von ein- oder mehrwertigen aliphatischen oder aromatischen Alkoholen. In allen Fällen können gegebenenfalls die aliphatischen und aromatischen Reste sowie auch die vinylischen C-Atome substituiert sein, vorzugsweise mit als Elektronenakzeptoren wirkenden, die Neigung zur Copolymerisation verstärkenden funktionellen Gruppen, wie etwa Halogen, Nitro, Sulfonyl, Carboxyl.

Bevorzugte Vinylverbindungen sind:
2-Hydroxyethylvinylether
2-Acetoxyethylvinylether
2-Benzoyloxyethylvinylether
Acroleindiethylacetal
Bis-Acrolein-pentaerythritacetal
2-Hydroxyethyl(meth)acrylat
Trimethylolpropantri(meth)acrylat
Pentaerythrittri(meth)acrylat
2-Hydroxyethylvinylsulfon
2-Acetoxyethylvinylsulfon
n-Pentylvinylsulfon
Phenylvinylsulfon
2,3-Bis-Phenylsulfonyl-butadien-1,3
Phenyl-(1-hydroxymethylvinyl)-sulfon
Besonders bevorzugt sind die Verbindungen:
2-Hydroxyethylvinylsulfon
Trimethylolpropantriacrylat
Bis-Acrolein-Pentaerythritacetal.

Alle diese Vinylverbindungen sind bekannt; sie sind entweder im Handel erhältlich oder lassen sich nach an sich bekannten Methoden leicht herstellen. Die als besonders bevorzugt genannte Verbindung 2-Hydroxyethyl-vinylsulfon kann auch gemäß USP-3 509 218 hergestellt werden.

Als Allylverbindungen kommen vornehmlich alle jene in Frage, die in der deutschen Patentanmeldung P-3 233 912 beschrieben sind, insbesondere jene, die dort als besonders bevorzugt genannt sind.

Besonders bevorzugt für den erfindungsgemäßen Zweck sind die Verbindungen:

Trimethylolpropantriallylether
Pentaerythrittriallylether
2,4,6-Trisallyloxy-1,3,5-triazin
Trisallyl-s-triazin-2,4,6-(1H,3H,5H)-trion

Bei den den Fotolacken erfindungsgemäß zusammen mit den Comonomeren zur Verkürzung der Bestrahlungszeiten zugesetzten Fotoinitiatoren handelt es sich um Verbindungen vom Typ der N-Azidosulfonylaryl-maleinimide. Solche Verbindungen sowie ihre Verwendung als Fotoinitiatoren bei der Herstellung von Reliefstrukturen sind in den Patentschriften DE-PS-2 919 823/USP-4 329 556 und DE-PS-2 919 841/USP-4 287 294 beschrieben.

Für den erfindungsgemäßen Verwendungszweck sehr gut geeignet sind die Verbindungen:

N-(4-Azidosulfonylphenyl)-maleinimid
2-(N-Maleinimido)-naphthyl-5-sulfonylazid
2-(N-Maleinimido)-naphthyl-6,8-bissulfonylazid.

Besonders bevorzugt ist die Verbindung N-(4-Azidosulfonylphenyl)-maleinimid.

Die erfindungsgemäßen Fotolacke enthalten die Comonomeren in der Regel in einem Anteil von 5 bis 35 Gew.-%, vorzugsweise 10 bis 30 Gew.-%, die Fotoinitiatoren in einem Anteil von 1 bis 10 Gew.-%, vorzugsweise 3 - 8 Gew.-%, bezogen auf die strahlungsreaktive, lösliche polymere Vorstufe.

Die in den erfindungsgemäßen Fotolacken enthaltenen Strahlungsreaktiven, löslichen polymeren Vorstufen sowie deren Herstellung sind aus den eingangs zitierten Patentschriften bekannt. Es sind dies Polyadditions- oder Polykondensationsprodukte polyfunktioneller carbocyclischer oder heterocyclischer, strahlungsreaktive Reste tragender Verbindungen mit Diaminen, Diisocyanaten, Bis-Säurechloriden oder Dicarbonsäuren.

Besonders bevorzugt sind lösliche Polyamidester-Präpolymere, die Polykondensate aus Pyromellithsäure, die zwei esterartig an Carboxylgruppen gebundene strahlungsreaktive Reste trägt, und einem mindestens ein cyclisches Strukturelement enthaltendes Diamin, wie beispielsweise 4,4'-Diaminodiphenylether, 4,4'-Diaminodiphenylmethan, 4,4'-Diaminodiphenylsulfon, 2,4-Diaminopyridin, darstellen.

Die vielfältigen strahlungsreaktiven Reste, die diese löslichen polymeren Vorstufen enthalten können, sind ebenfalls aus den eingangs zitierten Druckschriften bekannt.

Dabei sind besonders esterartig an Carboxylgruppen gebundene strahlungsreaktive Oxyallyl-, Oxyalkylacrylat- und Oxyalkylmethacrylatgruppen, wie etwa 2-Oxyethylacrylat- oder -methacrylatgruppen, ferner die in der deutschen Patentanmeldung P-3 227 584 beschriebenen Allyloxy- und/oder Allylthiogruppen enthaltenden Estergruppen bevorzugt. In einer besonderen Ausführungsform enthalten die erfindungsgemäßen Fotoresistzusammensetzungen lösliche Polyamidester-Präpolymere, deren strahlungsreaktive Gruppen teilweise oder vollständig 2-Oxyallylether- bzw. -thioethergruppen sind.

Die in den erfindungsgemäßen Fotorestist-Zusammensetzungen enthaltenen löslichen Polyamidester-Präpolymere haben in der Regel Molekulargewichte zwischen 2 000 und 100 000, vorzugsweise zwischen 4 000 und 60 000.

Diese löslichen Polyamidester-Präpolymere werden mit den erfindungsgemäß zuzusetzenden strahlungsreaktiven, copolymerisierbaren Comonomeren und Fotoinitiatoren in an sich bekannter Weise zu den erfindungsgemäßen Fotoresist-Zusammensetzungen verarbeitet, die außer einem geeigneten Lösungsmittel, dem löslichen Präpolymer, der (den) Vinyl- oder Allylverbindung(en) und der (den) Verbindung(en) vom Typ der N-Azidosulfonylaryl-maleinimide weitere in dieser Technologie bekannte und üblichen Zusatzstoffe enthalten können. Als Beispiele seien genannt Fotosensibilisatoren, wie beispielsweise 4,4'-Bis(dimethylamino)-benzophenon (Michlers Keton), 4,4'-Bis(diethylamino)-benzo-phenon, Benzoinether, Campherchinon, Anthrachinon- oder Thioxanthon-Derivate, ferner auch copolymerisierbare, strahlungsempfindliche Maleinimide wie beispielsweise N-Phenylmaleinimid, Farbstoffe, Pigmente, Weichmacher, Haftvermittler, wie beispielsweise Vinylsilane, thermisch aktivierbare, freie Radikale bildende Initiatoren, ferner auch die verschiedensten anderen Polymeren und Harze, Stabilisatoren sowie oberflächenaktive Verbindungen, die gegebenenfalls zur Verbesserung der filmbildenden Eigenschaften oder Beschichtungseigenschaften und/oder zur Verbesserung der Haftung der auf die Substrate aufgetragenen Schichten, zur Verbesserung der mechanischen Festigkeit, der chemischen Widerstandsfähigkeit, der Fließbeständigkeit des Materials, aber auch zur Beeinflussung der Viskosität der Fotolacke beitragen können. Solche Zusatzstoffe können in einer Menge von 0,1 bis 15 Gew.-%, bezogen auf den Feststoffgehalt, zugesetzt werden. In einer besonders bevorzugten Ausführungsform enthalten die erfindungsgemäßen Fotolacke 1 bis 15 Gew.-% an 4,4'-Bis(dimethylamino)-benzophenon (Michler's Keton) als zusätzlichen Fotosensibilisator.

Als Lösungsmittel, die die löslichen Polyamidester-Präpolymere und die vorgenannten Bestandteile der Fotolacke lösen können, eignen sich beispielsweise Ethylenglykol, Glykolether, wie Glykolmonomethylether, Glykoldimethylether und Glykolmonoethylether; aliphatische Ester wie Ethylacetat, Hydroxyethylacetat, Alkoxyethylacetat, n-Butylacetat oder Amylacetat; Ether wie Dioxan; Ketone wie Methylethylketon, Methyl-iso-butylketon, Cyclopentanon und Cyclohexanon; Dimethylformamid, Dimethylacetamid, Hexamethylphosphorsäuretriamid, N-Methylpyrrolidon, Butyrolacton, Tetrahydrofuran und Mischungen solcher Lösungsmittel. Diese Lösungen enthalten in der Regel 1 bis 60 %, vorzugsweise 5 bis 50 % an Feststoffen. Die erfindungsgemäßen Fotolacke können in der üblichen Weise auf alle hierfür gebräuchlichen Substrate aufgetragen werden, insbesondere auf an der Oberfläche thermisch oxidierte und/oder mit Aluminium beschichtete Siliziummaterialien, die gegebenenfalls auch dotiert sein können, ferner alle anderen in der Halbleitertechnologie üblichen Substrate wie z. B. Siliziumnitrid, Galliumarsenid, Indiumphospid. Weiterhin kommen infrage aus der Flüssigkristalldisplay-Herstellung bekannte Substrate wie Glas, Indium-Zinn-oxid; ferner Metallplatten und -folien, beispielsweise aus Aluminium, Kupfer, Zink; Bimetall- und Trimetallfolien, aber auch elektrisch nicht leitende Folien, die mit Metallen bedampft sind, gegebenenfalls mit Aluminium beschichtete $SiO_2$-Materialien, Papier. Diese Substrate können einer Temperatur-Vorbehandlung unterzogen werden, oberflächlich angerauht, angeätzt oder zur Verbesserung der Haftung mit Haftvermittlern behandelt sein.

Die Fotolackschichten können in verschiedener Stärke auf ein Substrat aufgetragen werden. Die im Einzelfalle vorteilhafteste Schichtstärke hängt von verschiedenen Faktoren ab, beispielsweise dem speziellen Verwendungszweck des herzustellenden Materials, der im Einzelfalle verwendeten polymeren Vorstufe und der Natur der anderen Komponenten, die gegebenenfalls in der strahlungsempfindlichen Schicht zugegen sein können. Als zweckmäßig hat es sich in der Regel erwiesen, wenn die Resistschichten eine Stärke von 0,1 µm bis 200 µm aufweisen.

Der Auftrag der Fotoresistschicht auf die saubere Oberfläche der Substrate kann durch Aufsprühen, Fließbeschichten, Walzen, Schleuderbeschichten und Tauchbeschichten erfolgen, wonach das Lösungsmittel durch Verdampfen entfernt wird, so daß auf der Oberfläche des Substrats eine strahlungsempfindliche Schicht zurückbleibt. Die Entfernung des Lösungsmittels kann gegebenenfalls durch Erhitzen der Schicht auf Temperaturen von bis zu 120°C gefördert werden. Anschließend wird die Fotoresistschicht der Strahlung ausgesetzt, welche die Reaktion der strahlungsreaktiven Gruppen unter Vernetzung der Schicht verursacht. Üblicherweise wird aktinisches Licht verwendet, aber auch energiereiche Strahlung wie Röntgen- oder Elektronenstrahlung. Die Bestrahlung oder Belichtung kann durch eine Maskenvorlage durchgeführt werden, es kann aber auch ein gebündelter Strahl der Strahlung über die Oberfläche der strahlungsempfindlichen Schicht geführt werden. Üblicherweise werden zur Bestrahlung UV-Lampen verwendet, die Strahlung einer Wellenlänge von 200 bis 500 nm und einer Intensität von 0,5 bis 60 mW/cm² aussenden. Die durch den erfindungsgemäßen Zusatz von strahlungsreaktiven Comonomeren und Fotoinitiator in der Lichtempfindlichkeit gesteigerten Fotoresistzusammensetzungen erlauben eine Reduktion der notwendigen Bestrahlungszeit auf Werte unter 30 Sekunden, insbesondere auf Werte unter 10 Sekunden. Letzteres entspricht einer Steigerung der Empfindlichkeit um mindestens den Faktor 3 gegenüber Fotoresist-Materialien nach dem Stand der Technik ohne den erfindungsgemäßen Zusatz an Comonomer und Initiator.

In der Schicht wird nun ein Bildmuster unter Freilegung von Teilen des Substrats entwickelt, indem die Schicht mit einer Entwicklerlösung behandelt wird, die die nicht bestrahlten Bereiche des Fotoresistmaterials entfernt. Als Entwicklerlösung wird in der Regel ein Gemisch aus einem oder mehreren der für die Herstellung der Fotoresist-Zusammensetzung angegebenen Lösungsmittel mit einem Fällungsmittel verwendet. Typische Entwicklerlösungen sind beispielsweise 4-Butyrolacton/Toluol, Dimethylformamid/ Ethanol, Dimethylformamid/Methanol, Methylethylketon/ Ethanol und Methyl-i-butylketon/i-Propanol, jeweils in Verhältnis 2 : 1 bis 1 : 4. Besonders günstig für die Entwicklung von Reliefbildern aus den erfindungsgemäßen Fotoresistzusammensetzungen ist eine Entwicklerflüssigkeit, die gemäß der deutschen Patentanmeldung P-3 246 403 nur aus einem aliphatischen Keton, vorzugsweise Cyclopentanon besteht. Nach Entwickeln, Waschen und Trocknen, werden kantenscharfe Resistbilder mit einer Auflösung von unter 3 µm erhalten, die durch Tempern bei 200 bis 400° in hochwärmebeständige Polymere überführt werden können.

Diese hochwärmebeständigen Polymeren haben ausgezeichnete chemische, elektrische und mechanische Eigenschaften. Die erfindungsgemäßen Fotoresist-Zusammensetzungen eignen sich somit beispielsweise zur Herstellung von Schutzschichten auf Halbleiterelementen, dielektrischen Schichten bei vielschichtigen integrierten Schaltungen, als letzte passivierende Schicht auf elektrischen Vorrichtungen, sowie als Orientierungsschicht von Flüssigkristallanzeigezellen.

Die nachfolgenden Beispiele A, B und C beinhalten Vergleichsversuche, in denen für Fotoresist-Materialien nach dem Stand der Technik die zu Erzeugung von kantenscharfen Reliefstrukturen mit einer Auflösung von weniger als 3 µm erforderlichen Mindestbelichtungszeiten ermittelt werden.

## Beispiel A

Fotoresist:

| | |
|---|---|
| 5 g | Polyamidester-Präpolymer (erhalten durch Umsetzung von Pyromellithsäuredianhydrid mit (2-Hydroxyethyl)-methacrylat und anschließend mit Thionylchlorid und 4,4'-Diaminodiphenylether gemäß der DE-PS-2 437 348) |
| 0,25 g | N-Phenyl-maleinimid |
| 0,1 g | Michlers Keton |
| 0,05 g | Vinyltrimethoxysilan |

werden in 13,5 ml Dimethylacetamid gelöst.

Anwendung:
Auf ein Substrat mit einer SiO$_2$-Oberfläche wird die Fotoresist-Zusammensetzung aufgeschleudert und durch Erwärmen getrocknet. Die erhaltene 1,5 µm starke Schicht wird anschließend unter Stickstoff im Kontaktverfahren mit einer Mindestbelichtungszeit von 180 Sekunden durch eine Auflösungstestmaske mit einer 200 Watt UV-Lampe mit einer Intensität von 5 - 6 mW/cm$^2$ bestrahlt. Anschließend werden die nicht bestrahlten Fotoresistbereiche durch Entwickeln mit einer Mischung aus gleichen Volumenteilen Toluol und 4-Butyrotacton ausgewaschen. Man erhält ein kantenscharfes Bild mit einer Auflösung von weniger als 3 µm.

## Beispiel B

Fotoresist:
Wie in Beispiel A, jedoch Zusatz von

| | |
|---|---|
| 0,25 g | N-(4-Azidosulfonylphenyl)-maleinimid |

Mindestbelichtungszeit: 30 Sekunden.

## Beispiel C

Fotoresist:
Wie in Beispiel A, jedoch Zusatz von

| | |
|---|---|
| 1,5 g | Trimethylolpropantriacrylat |

Mindestbelichtungszeit: 35 Sekunden.

In den nachfolgenden Beispielen 1 bis 8 werden Fotoresist-Zusammensetzungen mit dem erfindungsgemäßen Zusatz von Comonomer und Fotoinitiator getestet. Die Empfindlichkeit der Fotoresist-Zusammensetzungen wird mit gut bezeichnet, wenn die Mindestbelichtungszeit unter 30 Sekunden liegt; sie wird mit sehr gut bezeichnet, wenn die Mindestbelichtungszeit unter 10 Sekunden liegt.

## Beispiel 1

Fotoresist:
Wie in Beispiel A mit Zusatz von
1,0 g 2-Hydroxyethylvinylsulfon und
0,25 g N-(4-Azidosulfonylphenyl)-maleinimid
Mindestbelichtungszeit: 8 Sekunden
Empfindlichkeit: sehr gut

## Beispiel 2

Fotoresist:
Wie in Beispiel A mit Zusatz von
0,64 g Pentaerythrittriacrylat und
0,25 g N-(4-Azidosulfonylphenyl)-maleinimid
Empfindlichkeit: sehr gut

## Beispiel 3

Fotoresist:
Wie in Beispiel A mit Zusatz von
0,65 g 2,4,6-Trisallyloxy-1,3,5-triazin und
0,25 g N-(4-Azidosulfonylphenyl)-maleinimid
Empfindlichkeit: sehr gut.

## Beispiel 4

Fotoresist:
Wie in Beispiel A mit Zusatz von
1,3 g 2,3-Bis-phenylsulfonyl-butadien-1,3 und
0,25 g N-(4-Azidosulfonylphenyl)-maleinimid
Empfindlichkeit: sehr gut.

## Beispiel 5

Fotoresist:
Wie in Beispiel A mit Zusatz von
0,82 g Bis-acrolein-pentaerythritacetal und
0,25 g N-(4-Azidosulfonylphenyl)-maleinimid
Empfindlichkeit: sehr gut.

## Beispiel 6

Fotoresist:
Wie in Beispiel A mit Zusatz von
1,5 g 2-Benzoyloxyethylvinylether und
0,25 g N-(4-Azidosulfonylphenyl)-maleinimid
Empfindlichkeit: gut.

## Beispiel 7

Fotoresist:
Wie in Beispiel A mit Zusatz von 1,53 g Trimethylolpropantriacrylat und
0,25 g N-(4-Azidosulfonylphenyl)-maleinimid
Empfindlichkeit: sehr gut.

**Beispiel 8**

Fotoresist:
Wie in Beispiel A mit Zusatz von
1,25 g n-Pentylvinylsulfon und
0,25 g N-(4-Azidosulfonylphenyl)-maleinimid
Empfindlichkeit: gut.

**Beispiel 9**

Fotoresist:
Wie in Beispiel A, jedoch
5 g eines Polyamidester-Präpolymers, in dem
etwa 75 % der esterartig an Carboxylgruppen
gebundenen strahlungsreaktiven Reste (2-
Hydroxyethyl)-methacrylat und etwa 25 %
Glykolmonoallylether zugrunde liegt (erhalten
nach Beilspiel 6 der deutschen Patentanmeldung
P-3 227 584)
Zusatz von
0,83 g Trimethylolpropantriacrylat und
0,25 g N-(4-Azidosulfonylphenyl)maleinimid
Empfindlichkeit: sehr gut.

**Beispiel 10**

Fotoresist:
Wie in Beispiel A, jedoch
5 g eines Polyamidester-Präpolymers, in dem
etwa 75 % der esterartig an Carboxylgruppen
gebundenen strahlungsreaktiven Reste (2-
Hydroxyethyl)-methacrylat und etwa 25 % 2-
Hydroxyethyl-allyl-thioether zugrunde liegt
(erhalten nach Beispiel 8 der deutschen
Patentanmeldung P-3 227 584)
Zusatz von
0,34 g Pentaerythrittriallylether und
0,25 g N-(4-Azidosulfonylphenyl)maleinimid
Empfindlichkeit: sehr gut.

**Beispiel 11**

Fotoresist:
Wie in Beispiel A, jedoch
5 g eines Polyamidester-Präpolymers, in dem
den esterartig an Carboxylgruppen gebundenen
strahlungsreaktiven Resten ausschließlich
Glycolmonoallylether zugrunde liegt (erhalten
gemäß der deutschen Patentanmeldung P-3 227
584)
Zusatz von
1,28 g Pentaerythrittriallylether und
0,25 g N-(4-Azidosulfonylphenyl)-maleinimid
Empfindlichkeit: sehr gut.

**Patentansprüche**

1. Fotoresist-Zusammensetzungen zur
Ausbildung von Reliefstrukturen aus
hochwärmebeständigen Polymeren, enthaltend
lösliche Polyamidester-Präpolymere, die
esterartig an Carboxylgruppen gebundene,
strahlungsreaktive Reste tragen, dadurch
gekennzeichnet, daß zusätzlich
a) mindestens eine strahlungsreaktive,
copolymerisierbare Vinyl- oder Allylverbindung,
in der die Vinyl- bzw. Allylgruppe(n) über eine
funktionelle Gruppe gebunden ist (sind), als
Comonomer
und
b) mindestens eine Verbindung vom Typ der N-
Azidosulfonylarylmaleinimide als Fotoinitiator
enthalten sind.

2. Fotoresist-Zusammensetzungen nach
Anspruch 1, dadurch gekennzeichnet, daß in dem
Comonomer die Vinyl- bzw. Allylgruppe(n) über
ein Sauerstoff-, Schwefel- oder Stickstoffatom
oder eine Carbonyl-, Carboxyl-, SO- oder $SO_2$-
Gruppe gebunden ist (sind).

3. Fotoresist-Zusammensetzungen nach den
Ansprüchen 1 und 2, dadurch gekennzeichnet,
daß als Fotoinitiator N-(4-
Azidosulfonylphenyl)maleinimid enthalten ist.

4. Verwendung einer Kombination aus
a) mindestens einer strahlungsreaktiven,
copolymerisierbaren Vinyl- oder Allylverbindung,
in der die Vinyl- bzw. Allylgruppe(n) über eine
funktionelle Gruppe gebunden ist (sind),
und
b) mindestens einer Verbindung vom Typ der
N-Azidosulfonylarylmaleinimide
in Fotoresist-Zusammensetzungen zur
Ausbildung von Reliefstrukturen aus
hochwärmebeständigen Polymeren, enthaltend
lösliche Polyamidester-Präpolymere, die
esterartig an Carboxylgruppen gebundene
strahlungsreaktive Reste tragen.

5. Verfahren zur Herstellung von
Reliefstrukturen aus hochwärmebeständigen
Polymeren durch Beschichtung eines Substrates
mit einer Fotoresist-Zusammensetzung, Trocknen
der Schicht, bildmäßiges Belichten der Schicht
und Ablösen der nicht bestrahlten Schichtteile
und gegebenenfalls anschließendes Tempern der
erhaltenen Reliefstrukturen, dadurch
gekennzeichnet, daß die Beschichtung mit einer
Fotoresist-Zusammensetzung nach den
Ansprüchen 1 bis 3 erfolgt.

**Claims**

1. Photoresist-compositions for producing
relief structures consisting of highly heat-
resistant polymers, containing soluble polyamide
ester prepolymers which carry radiation-reactive
radicals bonded via ester-linkage to carboxyl
groups, characterised in that they additionally
contain

a) as a comonomer, at least one copolymerisable radiation-reactive vinyl or allyl compound in which the vinyl or allyl group(s) is (are) bonded via a functional group and

b) at least one compound of the N-azidosulphonalylarylmaleimide type as a photoinitiator.

2. Photoresist-compositions according to Claim 1, characterised in that, in the comonomer, the vinyl or allyl group(s) is (are) bonded via an oxygen, sulphur or nitrogen atom or a carbonyl, carboxyl, SO or $SO_2$ group.

3. Photoresist-compositions according to Claim 1 and 2, characterised in that N-(4-azidosulphonylphenyl)-maleimide is present as a photoinitiator.

4. Use of a combination of

a) at least one radiation-reactive copolymerisable vinyl or allyl compound in which the vinyl or allyl compound, is (are) bonded via a functional group and

b) at least one compound of the N-azidosulphonylarylmaleimide type

in photoresist-compositions for producing relief structures consisting of highly heat-resistant polymers, containing soluble polyamide ester prepolymers which carry radiation-reactive radicals bonded via ester-linkage to carboxyl groups.

5. Process for the production of relief structures consisting of highly heat-resistant polymers by coating a substrate with a photoresist-composition, drying the layer, exposing the layer imagewise, and removing the parts of the layer which have not been irradiated and, if required, then heating the relief structures obtained, characterised in that a photoresist-composition according to the claim 1 to 3 is applied.

**Revendications**

1. Compositions photoréserves pour la formation de structures de reliefs à partir de polymères très résistants à la chaleur, contenant des prépolymères esters de polyamides solubles qui portent des radicaux liés à la façon d'esters à des groupes carboxyle et réagissant aux rayonnements caractérisés en ce qu'elles comprennent en outre

a) au moins un composé vinyle ou allyle copolymérisable réagissant aux rayonnements où le(s) groupe(s) vinyle ou allyle est(sont) lié(s) par l'intermédiaire d'un groupe fonctionnel, comme comonomère et

b) au moins un composé du type des N-azidosulfonylaryl-maléinimides comme photoinducteur.

2. Compositions photoréserves selon la revendication 1, caractérisées en ce que dans le comonomère le(s) groupe(s) vinyle ou allyle est(sont) lié(s) par l'intermédiaire d'un atome d'oxygène, de soufre ou d'azote ou d'un groupe carbonyle carboxyle, SO ou $SO_2$.

3. Compositions photoréserves selon les revendications 1 et 2, caractérisées en ce qu'elles contiennent comme photoinducteur le N-(4-azidosulfonylphényl)-maléinimide.

4. Application d'une combinaison de

a) au moins un composé vinyle ou allyle copolymérisable réagissant aux rayonnements où le(s) groupe(s) vinyle ou allyle est(sont) lié(s) par l'intermédiaire d'un groupe fonctionnel, et b) au moins un composé du type des N-azidosulfonylaryl-maléinimides dans des compositions photoréserves pour la formation de structures de reliefs à partir de polymères très résistants à la chaleur, contenant des prépolymères esters de polyamides solubles qui portent des radicaux liés à la façon d'esters à des groupes carboxyle et réagissant aux rayonnements.

5. Procédé de fabrication de structures de reliefs à partir de polymères très résistants à la chaleur par recouvrement d'un substrat avec une composition photoréserve, séchage de la couche, éclairage de la couche par des images et élimination des parties de couche non irradiées puis éventuellement recuisson des structures de relief obtenues, caractérisé en ce que le recouvrement s'effectue avec une composition photoréserve selon les revendications 1 à 3.